(19) Europäisches Patentamt / European Patent Office / Office européen des brevets

(11) **EP 1 998 453 A1**

(12) **EUROPEAN PATENT APPLICATION**
published in accordance with Art. 158(3) EPC

(43) Date of publication:
**03.12.2008 Bulletin 2008/49**

(51) Int Cl.:
***H03M 7/30*** (2006.01)   ***H03M 13/29*** (2006.01)
***H04B 1/707*** (2006.01)

(21) Application number: **07739107.6**

(22) Date of filing: **20.03.2007**

(86) International application number:
**PCT/JP2007/055664**

(87) International publication number:
**WO 2007/108469 (27.09.2007 Gazette 2007/39)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **20.03.2006 JP 2006077818**

(71) Applicant: **NTT DoCoMo, Inc.**
**Chiyoda-ku**
**Tokyo 100-6150 (JP)**

(72) Inventors:
• **MIKI, Nobuhiko**
  **Chiyoda-ku, Tokyo;1006150 (JP)**
• **OKUBO, Naoto**
  **Chiyoda-ku, Tokyo;1006150 (JP)**
• **KISHIYAMA, Yoshihisa**
  **Chiyoda-ku, Tokyo;1006150 (JP)**
• **HIGUCHI, Kenichi**
  **Chiyoda-ku, Tokyo;1006150 (JP)**
• **SAWAHASHI, Mamoru**
  **Chiyoda-ku Tokyo 1006150 (JP)**

(74) Representative: **HOFFMANN EITLE**
**Patent- und Rechtsanwälte**
**Arabellastrasse 4**
**81925 München (DE)**

(54) **APPARATUS AND METHOD FOR PERFORMING CHANNEL CODING AND DECODING**

(57)   An encoding apparatus for use in a radio transmitter has a unit for turbo-SPC encoding a plurality of information bits which bits constitute a transmit signal, and deriving at least one set of redundant bits from one set of the information bits; and a redundancy-adjusting unit for decreasing or increasing the redundant bits according to a channel-encoding rate designated by a control signal, and adjusting the ratio of the number of the information bits to the number of the redundant bits. At least some of the redundant bits decreased or increased by the redundancy-adjusting unit are derived from an identical set of the information bits.

FIG.1

(TRANSMITTER)                (RECEIVER)

**Description**

**BACKGROUND OF THE INVENTION**

1. Field of the Invention

The present invention relates generally to wireless communications, and more specifically to channel encoding and decoding apparatuses and methods.

2. Description of the Related Art

In general, a transmit signal is channel-encoded, then wirelessly transmitted, and decoded at the receiver. This makes it possible to improve the error rate associated with the wireless transmission. Turbo encoding or convolution encoding is used in a W-CDMA system such as IMT-2000, while link adaptation is used in HSDPA (High-Speed datalink packet access) for changing data modulation and a channel-encoding rate according to the conditions of the channel. The ability to vary the channel-encoding rate is also desired in a next-generation communications system such as the forthcoming Long-Term Evolution (LTE). Such a technique as the turbo encoding is desirable for achieving high error-correcting capabilities and increased signal quality. However, there is a problem that its computation process is complex.
For simplifying the encoding and decoding computation processes, a turbo-Single Parity Check (turbo-SPC) encoding scheme may be used. However, with the turbo-SPC encoding scheme, there is a problem that there are no techniques for varying the channel-encoding rate while maintaining the expected effect of improvement in the error rate resulting from the channel-encoding rate, making the changing of the channel-encoding rate difficult.
Thus, it is difficult with conventional techniques to vary the channel-encoding rate in a simple configuration.

**SUMMARY OF THE INVENTION**

[Problem(s) to be solved by the Invention]

A problem to be solved by the present invention is to provide channel encoding and decoding apparatuses and methods used in a mobile communications system, which apparatuses and methods make it possible to simply and easily change the channel-encoding rate.

[Means for solving the Problem]

The present invention uses an encoding apparatus used in a radio transmitter. The encoding apparatus for use in a radio transmitter has a unit for turbo-SPC encoding plural information bits which constitute a transmit signal, and deriving at least one set of redundant bits from one set of the information bits; and a redundancy-adjusting unit for decreasing or increasing the redundant bits according to a channel-encoding rate designated by a control signal, and adjusting the ratio of the number of the information bits to the number of the redundant bits. At least some of the redundant bits decreased or increased by the redundancy-adjusting unit are derived from an identical set of the information bits.

[Advantage of the Invention]

The present invention makes it possible to simply and easily change the channel-encoding rate used in a mobile communications system in which channel encoding and decoding are performed.

**BRIEF DESCRIPTION OF THE DRAWINGS**

FIG. 1 illustrates a block diagram showing a portion of a transmitter that is involved in channel encoding and a portion of a receiver that is involved in channel decoding, according to one embodiment of the present invention;
FIG. 2 illustrates details, and a computation overview of the channel encoder;
FIG. 3 illustrates a state transition diagram of input bits ($q_k$, $q_{k+1}$) and output bits ($p_k$, $p_{k+1}$);
FIG. 4 illustrates a diagram showing an example of increasing the channel-encoding rate;
FIG. 5 illustrates a diagram showing a channel encoder;
FIG. 6 illustrates another diagram showing an example of increasing the channel-encoding rate;
FIG. 7 illustrates a diagram showing an example of decreasing the channel-encoding rate; and

# EP 1 998 453 A1

FIG. 8 illustrates another diagram showing an example of decreasing the channel-encoding rate.

## DESCRIPTION OF THE PREFERRED EMBODIMENTS

[Description of Notations]

12 information generator; 14 channel encoder;
16 redundancy-adjusting section; 18 adaptive modulation/demodulation controller; 20 redundancy-adjusting section;
22 channel decoder

[Best Mode of Carrying Out the Invention]

According to one embodiment of the present invention, the ratio of the number of information bits to the number of redundant bits is adjusted, so that the channel encoding rate is adjusted. At least some of the redundant bits that are decreased or increased are derived from the same set of the information bits. This may maintain the correspondence between a set of the information bits and a pair of the redundant bits, making it possible to achieve the expected effect of improvement of the error rate resulting from the channel encoding rate even with a change in the channel-encoding rate.

At least some of the redundant bits that are decreased or increased may be set such that, of a set of the redundant bits that is derived from the same set of the information bits, some are transmitted while the others are not transmitted. When the channel-encoding rate is close to 1, this makes it possible to uniformly distribute, among redundant bit sequences, redundant bits to be transmitted.

A predetermined number of the information bits are exclusive-ORed to derive a bit group. The sign of a bit within the bit group may be inverted or not inverted according to the bit group to derive a set of the redundant bits.

Embodiment 1

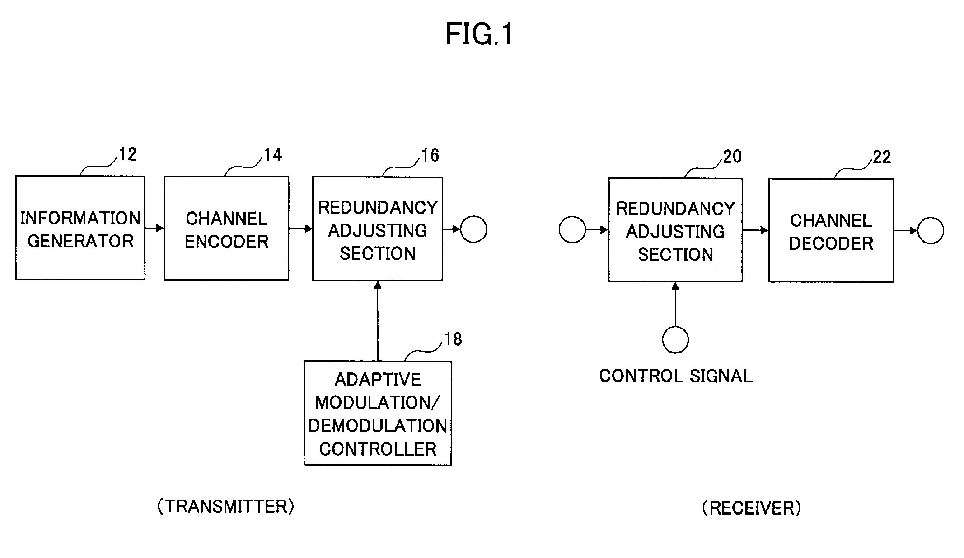

FIG. 1 shows a portion of a transmitter that is involved in channel encoding and a portion of a receiver that is involved in channel decoding, according to one embodiment of the present invention. (For brevity of illustration, other functional elements are omitted.) The transmitter and receiver, while referred to as such, are actually provided as transmitters and receivers in base stations, mobile stations and other wireless communications apparatuses.

FIG. 1 shows, at the transmitter, an information generator 12, a channel encoder 14, a redundancy-adjusting section 16, and an adaptive modulation/demodulation controller 18. Then, a redundancy-adjusting section 20 and a channel decoder 22 are shown at the receiver.

The information generator 12 generates information bits which constitute a transmit signal. The information bits may constitute a control channel or a data channel. The transmitter is provided, as needed, with the control and data channels as well as other channels which are not explicitly shown for brevity of illustration.

The channel encoder 14 channel encodes input information bits. In this embodiment, the channel encoding is performed using a turbo-Single Parity Check (turbo SPC) scheme.

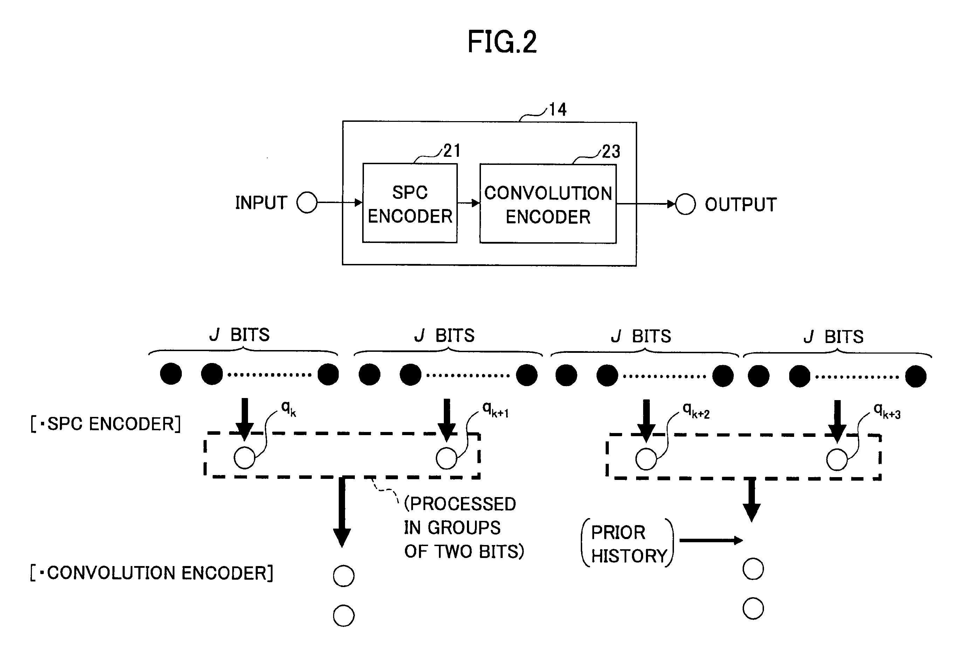

FIG. 2 shows details (top), and a computation overview (bottom) of the channel encoder 14. The channel encoder 14 has a SPC encoder 21 and a convolution encoder 23. The SPC encoder 21 outputs, for J information bits $(d_{k1}, d_{k2},...,d_{kJ})$ input, one input bit $q_k$ (one bit to be input to a later-stage processor). More specifically, the J information bits are all exclusive-ORed to derive the input bit.

$$q_k = d_{k1} (XOR) d_{k2} (XOR) ... (XOR) d_{kJ}$$

The thus-derived two input bits are convolution encoded as a set or as an input-bit pair (for example, $(q_k, q_{k+1})$) and output from the encoder 14. The convolution encoder 23 outputs output bits, or an output-bit pair $(p_k, p_{k+1})$ based on the input-bit pair and prior history. More specifically, with two states $(S_i=0,1)$ being defined, if the input-bit pair has the same signs, the state of the output-bit pair is set the same as the state of the input-bit pair. If the input-bit pair has different signs, the state of the output-bit pair is set as different from the state of the input-bit pair. Now, if the input-bit pair has one state (for example, Si=1), then the sign of the input bit is inverted to produce the output bit. Now, if the input-bit pair has the other state (for example, Si=0), then the sign of the input bit is not inverted, and the input bit is output (as it is) to produce the output bit.

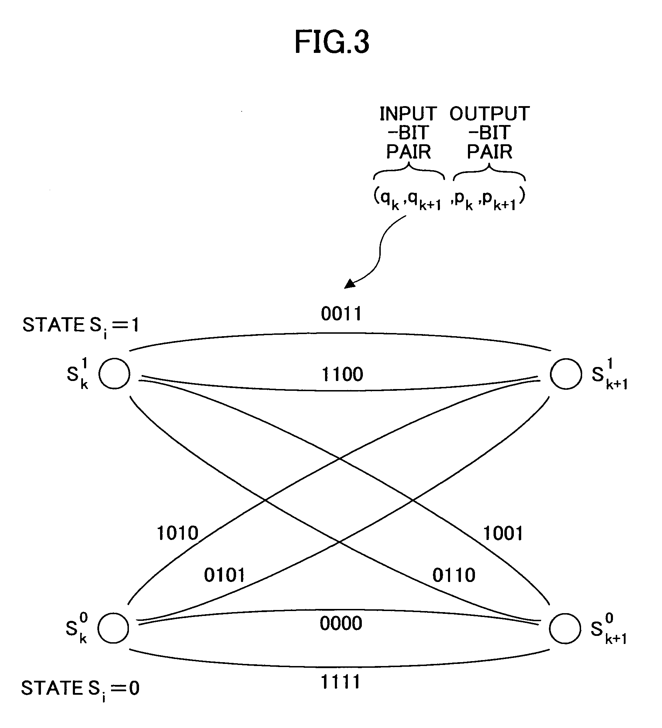

FIG. 3 illustrates a state transition diagram of input bits $(q_k, q_{k+1})$ and output bits $(p_k, p_{k+1})$. The input bits and output bits are illustrated together ($q_k,q_{k+1},p_k,p_{k+1}$). The input-bit pair consists of 2 bits, which can lead to a total of 4 kinds of the input-bit pairs (00), (11), (10), and (01). If Si=1, then the sign of the input-bit pair is inverted to form the output bits. Thus, the output-bit pairs become (11), (00), (01) and (10). With the former two the state is retained (Si=1) as the signs of the bits in the bit pair are the same, while with the latter two the state is changed (Si=0) as the signs are different. The same process is performed when Si=0. In this case, the sign of the input-bit pair is not inverted and output as it is to produce the output bits. Thus, the output-bit pairs become (00), (11), (10) and (01). With the former two the state is retained (Si=0) as the signs of the bits in the bit pair are the same, while with the latter two the state (Si=1) is changed as the signs are different.

The redundancy-adjusting section 16 in FIG. 1 adjusts the ratio of the number of the information bits to the number of the redundant bits, and produces a signal sequence of the channel coding rate designated by the adaptive modulation/demodulation controller 18 to output the sequence. The redundant bit is a bit corresponding to the output bit as described above. How to adjust the ratio of the number of the information bits to the number of the redundant bits will be described below. The redundant bit may be called a parity bit.

The adaptive modulation/demodulation controller 18 controls the modulation scheme and channel-encoding rate to apply to the transmit signal. The modulation scheme may be set to any of different modulation schemes such as QPSK, 16QAM and 64QAM, for example. The channel-encoding rate may be set to any of different rational numbers between 0 and 1. Combinations of the modulation scheme and the channel-encoding rate may be placed in advance in a table for each information rate, and the combination designated to derive the channel-encoding rate. Such a table may be called a MCS table.

The redundancy-adjusting section 20 at the receiver also adjusts the ratio of the number of the information bits to the number of the redundant bits, and produces a signal sequence of the channel coding rate designated by the a control signal to output the sequence. More specifically, a control signal which indicates the modulation scheme and the channel-encoding rate applied to the transmit signal is transmitted from the transmitter to the receiver. The receiver may receive and analyze the control signal to find out the modulation scheme and the channel encoding rate.

The channel decoder 22 decodes the turbo-SPC encoded signal sequence to output the sequence. At the receiver, the transmission is restored based on the decoded signal.

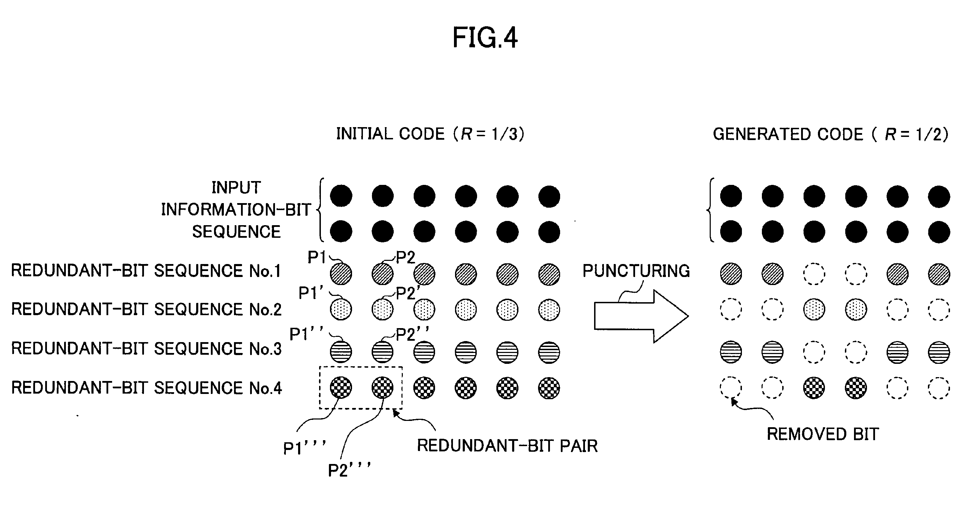

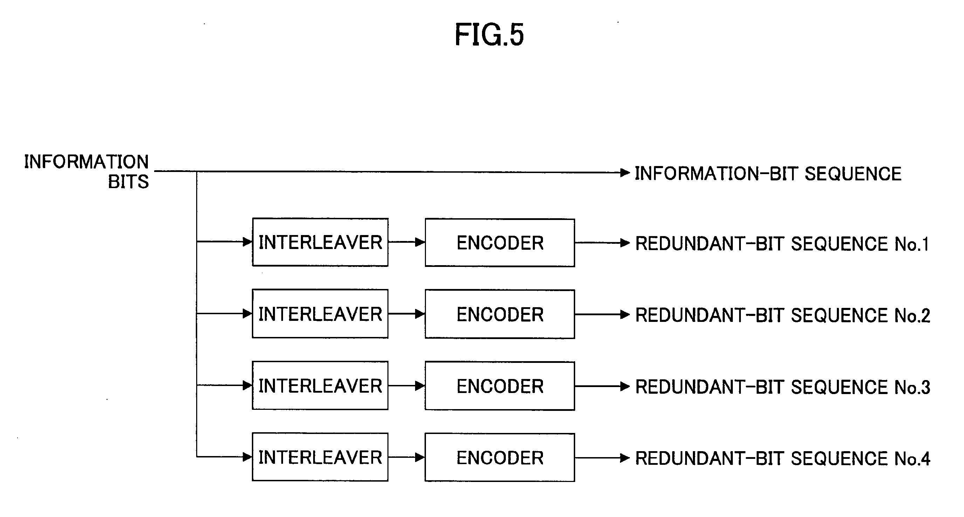

FIG. 4 shows an example of adjusting the channel-encoding rate. As shown on the left in FIG. 4, this example shows the input-bit sequence over 2 lines (6 bits per line), and the redundant-bit sequences over 4 lines (6 bits per line). Thus, the ratio of the number of the information bits to the number of the redundant bits is 1/3, which corresponds to the channel-encoding rate. Thus, elements for generating four sequences of the redundant bits as shown in FIG. 5 are used. The encoding process as illustrated in FIG. 2 is performed at each of the elements for generating the redundant-bit sequences. The number of the elements for generating the redundant bit-sequences that are provided as hardware does not necessarily have to be four. One element for generating the redundant bit-sequences may be used repeatedly to provide the redundant-bit sequences required.

On the right in FIG. 4 is shown the state after the channel-encoding rate R is changed from 1/3 to 1/2. In other words, the signal sequences as shown on the left in FIG. 4 are generated at the channel encoder 14 in FIG. 1, and the signal sequences as shown on the right in FIG. 4 are output from the redundancy-adjusting section 16. The redundant bits shown in broken-line circles in FIG. 4 are not provided to a later-stage transmitter (not shown), and are not wirelessly transmitted. In this way, half of the redundant bits which realize R=1/3 may be removed to realize R=1/2. Care is needed with respect to which redundant bit is to be removed. In this embodiment, redundant bits derived in the form of a pair are removed or retained in the same pair-form. Such a pair corresponds to the output-bit pair ($p_k,p_{k+1}$). "Removing" the redundant bits may be called "puncturing".

In the example as shown in FIG. 4, one input-bit pair ($q_1,q_2$) is derived from two sets of two information bits. A redundant-bit pair($p_1,p_2$) in the redundant bit sequence No. 1, a redundant-bit pair($p_{1'},p_{2'}$) in the redundant bit sequence No.2, a redundant-bit pair ($p_{1''},p_{2''}$) in the redundant bit sequence No. 3, and a redundant-bit pair ($p_{1'''},p_{2'''}$) in the redundant bit sequence No. 4 are derived from the input-bit pair (q1,q2). As shown on the right in FIG. 4, of the above, the redundant-bit pair ($p_1,p_2$) in the redundant bit sequence No. 1 and the redundant-bit pair ($p_{1''},p_{2''}$) in the redundant bit sequence No. 3 are retained, while the redundant-bit pair ($p_{1'},p_{2'}$) in the redundant bit sequence No. 2 and the redundant-bit pair ($p_{1'''},p_{2'''}$) in the redundant bit sequence No. 4 are removed.

The redundant bits are not reduced merely to set the ratio of the number of the information bits to the number of the redundant bits to be 1/2. Rather, when two of the redundant bits are removed, those redundant bits associated with the same input-bit pair ($q_1,q_2$) (or ($q_k,q_{k+1}$) in general terms) are removed together to realize the channel-encoding rate of 1/2. The redundant bits being removed in the form of pairs of bits means that the retained bits are retained also in the form of pairs of bits. In other words, before and after the channel-encoding rate adjusting, a redundant-bit pair corresponding to a set of information bits (input-bit pair) is retained, facilitating an accurate restoration of the information bits based on the redundant-bit pair. Allowing the pair form to collapse and reducing the redundant bits such as to merely set the ratio of the number of the information bits to the number of the redundant bits to be 1/2 may make achieving the improved error rate expected from the channel-encoding rate of 1/2 difficult.

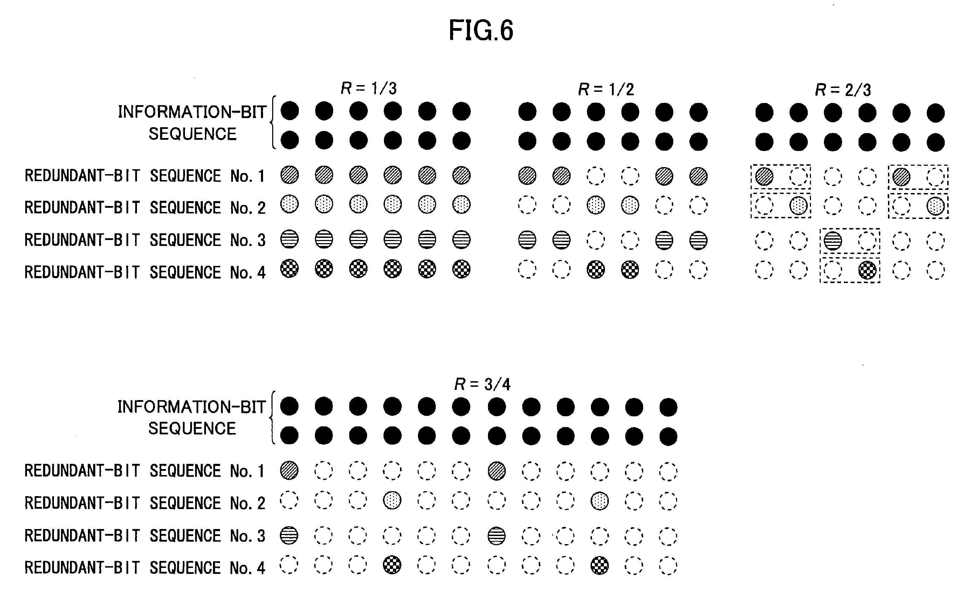

FIG. 6 shows another example of increasing the channel-encoding rate. FIG. 6 shows examples with the channel-encoding rate R of 1/3, 1/2, 2/3 and 3/4, respectively. The examples with R of 1/3 and 1/2, which are the same as in FIG. 4, are shown for the purpose of comparing with other examples. In the example with R of 2/3, more redundant bits are removed than in the example with R of 1/2. As shown, at least some of the removed redundant bits are redundant-bit pairs derived from the same input-bit pair, but the pair form is not maintained with respect to retained redundant bits. The redundant-bit pairs are shown enclosed in broken-line frames. Allowing the pair form to collapse for the example with R=2/3 is for the purpose of making the distribution of the retained redundant bits uniform. The redundant bits are removed such that they are retained uniformly from the redundant-bit sequences Nos. 1-4. As the channel-encoding rate approaches 1, it is preferable from the point of view of reception quality to allow the pair form to be collapsed and retain the redundant bits uniformly from the redundant-bit sequences rather than to maintain the pair form to retain the redundant bits of the same redundant-bit sequence and produce variations among the redundant-bit sequences. In the example with R=3/4, more redundant bits are removed also so that the redundant bits are distributed as uniformly as possible among the redundant-bit sequences.

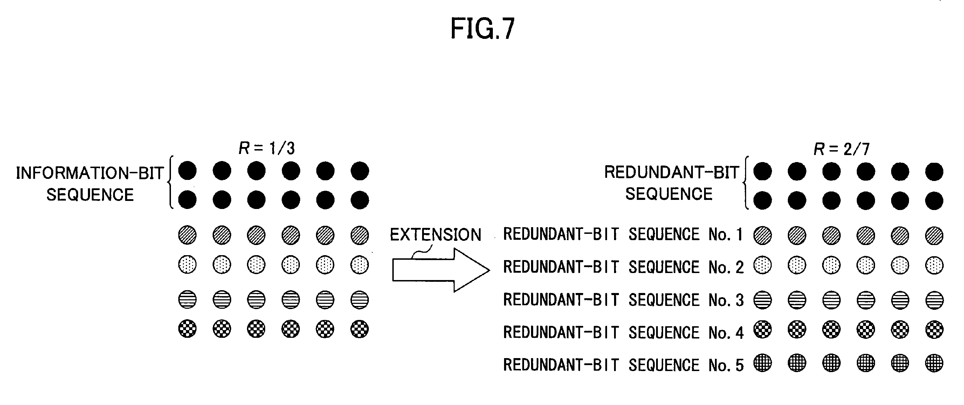

FIG. 7 shows an example of decreasing the channel-encoding rate. While FIGS. 4 and 6 show examples of increasing the channel-encoding rate, FIG. 7 shows how the channel-encoding rate is decreased from 1/3 to 2/7. In the example shown, a fifth redundant-bit sequence is added to first through fourth redundant-bit sequences NOS. 1-4. The fifth redundant-bit sequence NO. 5 is obtained by providing one more series of elements including the encoder as shown in FIG.5, or by incrementing by 1 the number of repetitive uses of the encoder. Alternatively, some of the redundant-bit sequences that are already obtained may be duplicated to derive the fifth redundant-bit sequence. At any rate, the number of redundant-bit sequences may be increased to decrease the channel-encoding rate. Moreover, the redundant bits are added such that the form of the pair of the redundant bits that corresponds to a set of information bits (an input-bit pair) is maintained, making it possible to expect an effect of an improved error rate according to a decrease in the channel-encoding rate. The "addition" of the redundant bits may also be called an "extension".

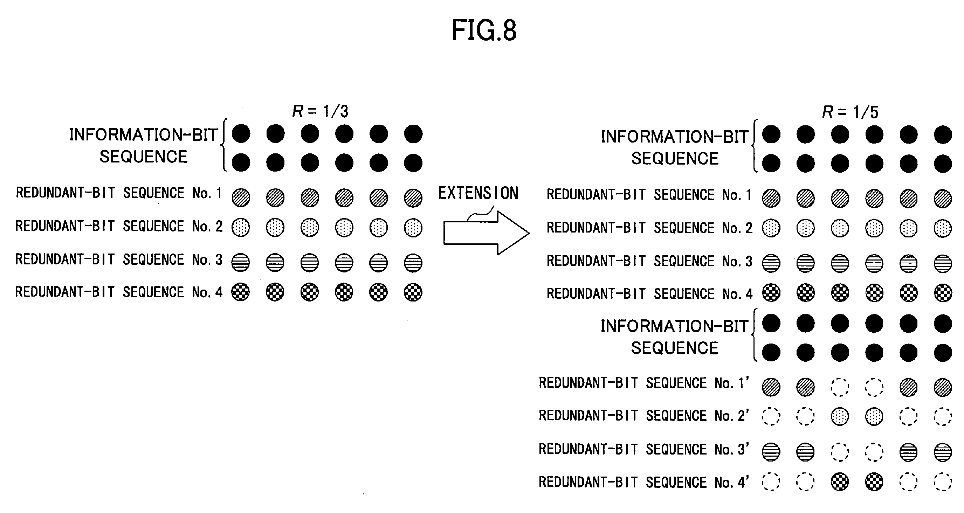

FIG. 8 shows an example of decreasing the channel-encoding rate to 1/5. In the example shown, duplicates of some of each of the first to fourth redundant-bit sequences NOS. 1-4 are made and the duplicates are added to the redundant bits to decrease the channel-encoding rate. The information bits as well as the redundant bits are duplicated. In this case, the form of the pair of the redundant bits that corresponds to a set of information bits (an input-bit pair) is also maintained before and after the redundancy adjusting, making it possible to expect an effect of an improved error rate according to a decrease in the channel-encoding rate.

The present invention is not limited to the above-described preferred embodiments, so that variations and modifications are possible within the scope of the spirit of the present invention. The present invention has been described by breaking down the description into a number of embodiments for the convenience of explanation. However, the breakdown of each of the embodiments is not essential to the present invention, so that one or more embodiments may be used as required.

The present application claims priority based on Japanese Patent Application No. 2006-077818 filed on March 20, 2006 with the Japanese Patent Office, the entire contents of which are hereby incorporated herein by reference.

**Claims**

1. An encoding apparatus for use in a radio transmitter, comprising:

   a unit for turbo-SPC encoding a plurality of information bits which bits constitute a transmit signal, and deriving at least one set of redundant bits from one set of the information bits; and
   a redundancy-adjusting unit for decreasing or increasing the redundant bits according to a channel-encoding rate designated by a control signal, and adjusting the ratio of the number of the information bits to the number of the redundant bits, wherein
   at least some of the redundant bits decreased or increased by the redundancy-adjusting unit are derived from an identical set of the information bits.

2. The encoding apparatus as claimed in claim 1, wherein at least some of the redundant bits that are decreased or increased by the redundant-adjusting unit are set such that, of the set of the redundant bits that is derived from the identical set of the information bits, some bits are transmitted while the others are not transmitted.

3. The encoding apparatus as claimed in claim 1, wherein a predetermined number of the information bits are exclusive-ORed to derive a bit group, and a sign of a bit within the bit group is inverted or not inverted according to the bit group to derive the set of the redundant bits.

4. A decoding apparatus for use in a radio receiver, comprising:

a redundancy-adjusting unit for increasing or decreasing bits representing a receive signal according to a channel-encoding rate indicated by a control signal received from a transmitter, and outputting a turbo-SPC encoded signal; and
a unit for decoding a signal output, wherein
at least one of the bits decreased or increased by the redundancy-adjusting unit is a redundancy bit derived from a set which is identical to a set of information bits prior to the SPC encoding.

5. A method of encoding, the method being for use in a radio transmitter, the method comprising the steps of:

turbo-SPC encoding a plurality of information bits which bits constitute a transmit signal, and deriving at least one set of redundant bits from one set of the information bits; and
decreasing or increasing the redundant bits according to a channel-encoding rate designated by a control signal, and adjusting the ratio of the number of the information bits to the number of the redundant bits,

wherein
at least one of the redundant bits decreased or increased is a redundant bit derived from a set identical to the set of the information bits.

6. A method of decoding, the method being for use in a radio receiver, the method comprising:

an adjusting step of increasing or decreasing bits representing a receive signal according to a channel-encoding rate indicated by a control signal received from a transmitter, and outputting a turbo-SPC encoded signal; and
a step of decoding the signal output, wherein
at least one of the bits decreased or increased by the adjusting step is a redundancy bit derived from a set which is identical to a set of information bits prior to the turbo-SPC encoding.

# FIG.1

(TRANSMITTER)

(RECEIVER)

CONTROL SIGNAL

EP 1 998 453 A1

# FIG.2

# FIG.3

INPUT OUTPUT
-BIT -BIT
PAIR PAIR

$(q_k, q_{k+1}, p_k, p_{k+1})$

STATE $S_i = 1$

0011

$S_k^1$  1100  $S_{k+1}^1$

1010  1001

0101  0110

$S_k^0$  0000  $S_{k+1}^0$

STATE $S_i = 0$  1111

# FIG.4

INITIAL CODE ($R = 1/3$)   GENERATED CODE ($R = 1/2$)

INPUT
INFORMATION-BIT
SEQUENCE

REDUNDANT-BIT SEQUENCE No.1

REDUNDANT-BIT SEQUENCE No.2

REDUNDANT-BIT SEQUENCE No.3

REDUNDANT-BIT SEQUENCE No.4

P1   P2
P1'   P2'
P1''   P2''
P1'''
P2'''

PUNCTURING

REDUNDANT-BIT PAIR

REMOVED BIT

EP 1 998 453 A1

# FIG.5

INFORMATION BITS ──────────────────────────────→ INFORMATION-BIT SEQUENCE

| INTERLEAVER | → | ENCODER | → REDUNDANT-BIT SEQUENCE No.1

| INTERLEAVER | → | ENCODER | → REDUNDANT-BIT SEQUENCE No.2

| INTERLEAVER | → | ENCODER | → REDUNDANT-BIT SEQUENCE No.3

| INTERLEAVER | → | ENCODER | → REDUNDANT-BIT SEQUENCE No.4

EP 1 998 453 A1

# FIG.6

# FIG.7

EP 1 998 453 A1

$R = 1/3$

INFORMATION-BIT
SEQUENCE

EXTENSION

$R = 2/7$

REDUNDANT-BIT
SEQUENCE

REDUNDANT-BIT SEQUENCE No. 1

REDUNDANT-BIT SEQUENCE No. 2

REDUNDANT-BIT SEQUENCE No. 3

REDUNDANT-BIT SEQUENCE No. 4

REDUNDANT-BIT SEQUENCE No. 5

# FIG.8

EP 1 998 453 A1

## INTERNATIONAL SEARCH REPORT

| | International application No. |
|---|---|
| | PCT/JP2007/055664 |

**A. CLASSIFICATION OF SUBJECT MATTER**
*H03M7/30* (2006.01) i, *H03M13/29* (2006.01) i, *H04B1/707* (2006.01) i

According to International Patent Classification (IPC) or to both national classification and IPC

**B. FIELDS SEARCHED**

Minimum documentation searched (classification system followed by classification symbols)
H03M7/30, H03M13/29, H04B1/707

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | K. Wu et al., An Improved Two-State Turbo-SPC Code for Wireless Communication Systems, IEEE Transactions on Communications, Vol.52, No.8, pp.1238-1241, August 2004 | 1-6 |
| Y | JP 2003-69531 A  (Mitsubishi Electric Corp.), 07 March, 2003 (07.03.03), Par. Nos. [0055] to [0058]; Figs. 1, 3 & US 2004/37262 A1        & EP 1420531 A1 & WO 2003/019832 A1     & CN 1479982 A | 1-6 |
| Y | JP 11-237997 A  (Oki Electric Industry Co., Ltd.), 31 August, 1999 (31.08.99), Par. No. [0009] (Family: none) | 3 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 May, 2007 (07.05.07) | 15 May, 2007 (15.05.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2007/055664

| C (Continuation). DOCUMENTS CONSIDERED TO BE RELEVANT | | |
|---|---|---|
| Category* | Citation of document, with indication, where appropriate, of the relevant passages | Relevant to claim No. |
| A | L. Ping, Turbo-SPC Codes, IEEE Transactions on Commnications, Vol.49, No.5, pp.754-759, May 2001 | 1-6 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006077818 A